# EUROPEAN PATENT APPLICATION

(11) **EP 1 544 899 A2**
(43) Date of publication of application: **22.06.2005**
(21) Application number: 04257827.8
(22) Date of filing: 16.12.2004
(51) Int. Cl.: H01L 21/02, H01L 29/92

(54) **Nonvolatile capacitor of a semiconductor memory device, and method of operating the same**

(30) Priority: 17.12.2003 KR 2003092614
(71) Applicant: Samsung Electronics Co., Ltd., Suwon-si, Gyeonggi-do (KR)
(72) Inventor: Lee, Jung-hyun, 106-803 Taeyoung Leisvill Apt., Yongin-si, Gyeonggi-do (KR); Lee, Myoung-jae, 813-1703 Hansin Apt., Suwon-si, Gyeonggi-do (KR); Park, Sung-ho, Seoul (KR); Park Young-soo, 204-502 Dongsuwon LG Village, Suwon-si, Gyeonggi-do (KR)
(74) Representative: Ertl, Nicholas Justin

(57) **Abstract**

The capacitor includes: a lower electrode (40); a dielectric layer (42) stacked on the lower electrode and including a phase-transition layer (42b), which displays two remarkably different resistance characteristics after insulating property thereof is changed; and an upper electrode (44) stacked on the dielectric layer.

The dielectric layer may include first and second insulating layers of silicon oxide, tantalum oxide or aluminium oxide for example. The phase-transition layer (42b) may be an oxide of group-V element and preferably is niobium oxide.

## Description

### BACKGROUND OF THE INVENTION

The present invention relates to a semiconductor device and a semiconductor memory device comprising the same, and more particularly, to a nonvolatile capacitor of a semiconductor device, a semiconductor memory device comprising the capacitor, and a method of operating the memory device.

A semiconductor memory device basically comprises a transistor and a capacitor. In recent years, various storage media have been developed as substitutes for capacitors. Among them, a magnetic tunneling junction (MTJ) cell included in a magnetic memory device is representative.

It is desirable that the semiconductor memory device has high integration, high operation speed, and nonvolatility superior enough not to lose data stored therein even after power is switched off.

Among widely used semiconductor memory devices, a dynamic random access memory (DRAM) has advantages of high integration and high operation speed, but does not has nonvolatility. Accordingly, the DRAM loses all data after power is switched off.

A flash memory has nonvolatility in contrast to the DRAM, but has lower integration and operation speed than the DRAM.

### SUMMARY OF THE INVENTION

According to an aspect of the present invention, there is provided a capacitor of a semiconductor device, the capacitor comprising: a lower electrode; a dielectric layer stacked on the lower electrode and including a phase-transition layer, which displays two remarkably different resistance characteristics after insulating property on thereof is changed; and an upper electrode stacked on the dielectric layer.

The dielectric layer may comprise a first insulating layer stacked on the lower electrode, the phase-transition layer stacked on the first insulating layer, and a second insulating layer stacked on the phase-transition layer.

Each of the first and second insulating layers may be a dielectric layer with a dielectric constant greater than that of the phase-transition layer.

The dielectric layer may be one of a silicon oxide layer, a tantalum oxide layer and an aluminum oxide layer.

The phase-transition layer may be a dielectric layer, which displays two remarkably different resistance characteristics according to a range of an applied voltage while at least one component of the phase-transition layer is separated by electrons injected into the phase-transition layer. In this case, the phase-transition layer may be a niobium oxide layer.

A thickness ratio of the first insulating layer, the phase-transition layer, and the second insulating layer may be 5:6:5.

According to another aspect of the present invention, there is provided a semiconductor memory device including a transistor and a capacitor, the capacitor comprising: a lower electrode; a dielectric layer stacked on the lower electrode and including a phase-transition layer, which displays two remarkably different resistance characteristics after insulating property thereof is changed; and an upper electrode stacked on the dielectric layer.

The dielectric layer may be the dielectric layer provided according to the one aspect of the present invention.

According to yet another aspect of the present invention, there is provided a method of operating a semiconductor memory device including a transistor and a capacitor, wherein the capacitor comprises a lower electrode, a dielectric layer including a phase-transition layer, which displays two remarkably different resistance characteristics after insulating property thereof is changed, and an upper electrode, the method comprising: changing insulating property of the phase-transition layer; and applying a write voltage to the capacitor while leaving the transistor turned on.

The insulating property of the phase-transition layer may be changed by injecting electrons to the phase-transition layer, and the electrons may be injected to the phase-transition layer by applying a voltage to the capacitor.

According to still another aspect of the present invention, there is provided a method of operating a semiconductor memory device including a transistor and a capacitor, wherein the capacitor comprises a lower electrode, a dielectric layer including a phase-transition layer, which displays two remarkably different resistance characteristics after insulating property thereof is changed, and an upper electrode, the method comprising: measuring a current by applying a read voltage to the capacitor while leaving the transistor turned on; and comparing the measured current value with a reference value.

Accordingly, the semiconductor memory device has advantages of both a DRAM and a flash memory device, that is, is fast in data processing as the DRAM and is as nonvolatile as the flash memory device such that data stored therein are not lost even after power is switched off.

The invention thus provides a nonvolatile capacitor of a semiconductor device, a nonvolatile semiconductor memory device comprising the capacitor, which is as fast in operation as a dynamic random access memory (DRAM) and has the same nonvolatile as a flash memory device. The present invention further provides a method of operating the semiconductor memory device

### BRIEF DESCRIPTION OF THE DRAWINGS

The above and other features and advantages of the present invention will become more apparent by describing in detail exemplary embodiments thereof with reference to the attached drawings in which:
FIG. 1 is a cross-sectional view of a nonvolatile capacitor of a semiconductor device according to an embodiment of the present invention;
FIG. 2 is a graph illustrating operational characteristics of the capacitor of FIG. 1;
FIG. 3 is a graph illustrating endurance test results for the capacitor of FIG. 1;
FIG. 4 is a cross-sectional view of a semiconductor memory device according to an embodiment of the present invention, the semiconductor memory device comprising the capacitor of FIG. 1; and
FIG. 5 is a graph illustrating various phases of a niobium oxide layer according to the content of oxygen.

### DETAILED DESCRIPTION OF THE INVENTION

The present invention will now be described more fully with reference to the accompanying drawings, in which preferred embodiments of the invention are shown. The thicknesses of layers and regions shown throughout the drawings are exaggerated for clarity.

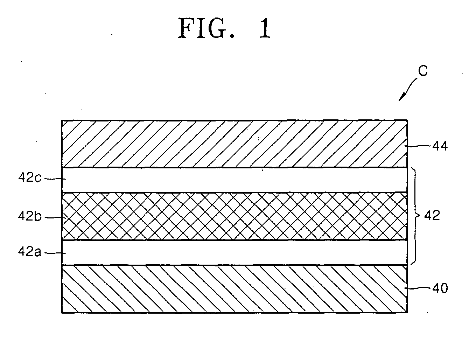

Referring to FIG. 1, a nonvolatile capacitor C of a semiconductor device according to an embodiment of the present invention includes a lower electrode 40, a dielectric layer 42, and an upper electrode 44. Here, the lower electrode 40 may be a platinum electrode. The upper electrode 44 may be a ruthenium electrode. The lower electrode 40 and the upper electrode 44 may be made of different materials from each other, and the materials of the lower and upper electrodes 40 and 44 are generally determined by the kind of the dielectric layer 42. The dielectric layer 42 includes a first insulating layer 42a, a phase-transition layer 42b stacked on the first insulating layer 42a, and a second insulating layer 42c stacked on the phase-transition layer 42b. Other material layer may be further interposed between the lower electrode 40 and the first insulating layer 42a, and other material layer may also be interposed between the second insulating layer 42c and the upper electrode 44. The first insulating layer 42a is a dielectric layer having a predetermined thickness and dielectric constant. For example, the first insulating layer 42a may be a silicon oxide layer, a tantalum oxide layer, or an aluminium oxide layer. The second insulating layer 42c is preferably identical to the first insulating layer 42a but may be a dielectric layer different from the first insulating layer 42a.

It is preferable that a voltage (referred to as a third voltage hereinafter) being applied to the phase-transition layer 42b of the capacitor C shown in FIG. 1 is equal to or greater than a voltage (referred to as a first voltage hereinafter) being applied to the first insulating layer 42a or a voltage (referred to as a second voltage hereinafter) being applied to the second insulating layer 42c.

A voltage being applied to each component of the capacitor is inversely proportional to the capacitance of the component. To make the third voltage equal to or greater than the first and second voltages, the capacitances of the first insulating layer 42a and the second insulating layer 42c must be equal to or greater than the capacitance of the phase-transition layer 42b.

Accordingly, when thicknesses and facing areas of the first and second insulating layers 42a and 42c, and the phase-transition layer 42b are equal to one another, it is preferable that the phase-transition layer 42b is a dielectric layer having a dielectric constant less than that of the first and second insulating layers 42a and 42c. For example, the phase-transition layer 42b may be a niobium oxide layer (Nb2O5) of a predetermined thickness.

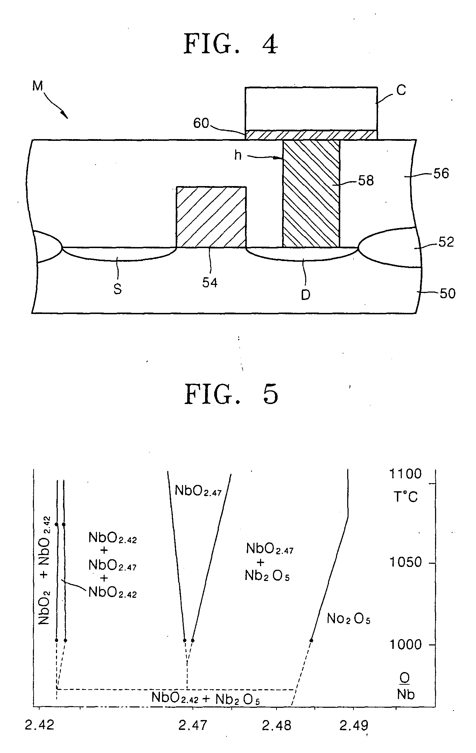

When the phase-transition layer 42b is a niobium oxide layer showing various phases according to the content of oxygen as shown in FIG. 5, electrons are injected to the phase-transition layer 42b such that at least one oxygen atom of the niobium oxide layer is separated and the insulating property of the phase-transition layer 42b is changed. The first and second insulating layers 42a and 42c prevent the separated oxygen atom from being discharged out of the phase-transition layer 42b.

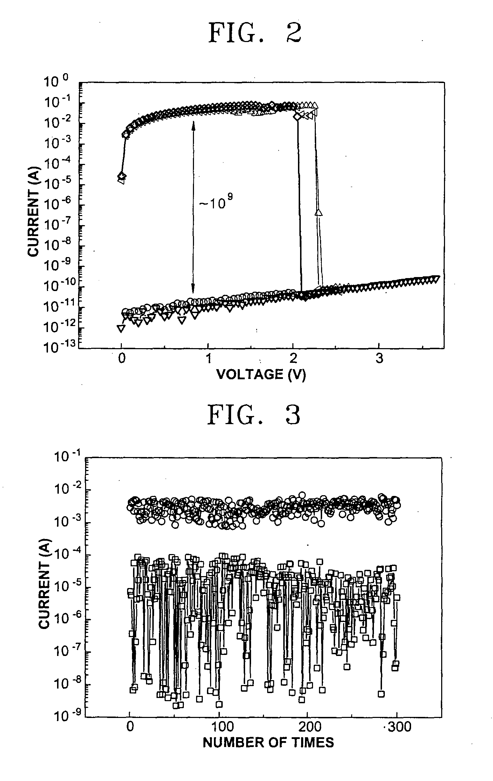

FIG. 2 is a graph illustrating resistance characteristics of a capacitor (referred to as a to-be-tested capacitor) comprising a platinum electrode as the lower electrode 40, a ruthenium electrode as the upper electrode 44, a tantalum oxide layer of 50Å as the first insulating layer 42a, a niobium oxide layer of 60Å as the phase-transition layer 42b, and a tantalum oxide layer of 50Å as the second insulating layer 42c.

Symbols Δ and ◇ in the graph of FIG. 2 represent a current change of the to-be-tested capacitor when a voltage is applied to the to-be-tested capacitor with the phase-transition layer 42 whose insulation is destroyed. That is, symbols Δ and ◇ represent a resistance change of the to-be-tested capacitor.

Referring to symbols Δ and ◇ in the graph of FIG. 2, a current of the to-be-tested capacitor measured when the voltage is applied to the to-be-tested capacitor with the phase-transition layer 42b whose insulation is destroyed is approximately 10⁻²A. However, as the voltage applied to the to-be-tested capacitor exceeds a predetermined value, for example, 2V, the current of the to-be-tested capacitor drastically decreases to approximately 10⁻¹¹A. This means that the resistance of the to-be-tested capacitor drastically increases. Further, although any high voltage is applied to the capacitor after the current of the to-be-tested capacitor decreases to approximately 10⁻¹¹A, the current of the to-be-tested capacitor does not increase much.

Hereinafter, the to-be-tested capacitor with the phase-transition layer 42b whose insulation is destroyed is referred to as a first state capacitor, a voltage when a relatively greater current is measured in the first state capacitor is referred to as a first voltage, and a voltage when a current fairly lower than the current at the first voltage is measured is referred to as a second voltage.

Symbols ∇ and O in the graph of FIG. 2 represent a current change of the first state capacitor when the current of the first state capacitor is drastically lowered by applying the second voltage to the first state capacitor and then the first voltage is applied to the first state capacitor.

Referring to symbols ∇ and O in the graph of FIG. 2, although the first voltage is applied to the first state capacitor after the current of the first state capacitor is drastically lowered by applying the second voltage to the first state capacitor, the current of the first state capacitor does not increase. This means that after the resistance of the first state capacitor is raised by applying the second voltage to the first state capacitor, although any voltage is applied to the first state capacitor, the high resistance of the first state capacitor is maintained.

Data can be stored in a nonvolatile state in the capacitor C having such current characteristics, namely, resistance characteristics. For example, if the current of the first state capacitor is high, namely, if the resistance of the first state capacitor is low, it may be considered that an arbitrary data, e.g., a bit data 1, is written. If the resistance of the first state capacitor high, it may be considered that another arbitrary data, e.g., a bit data 0, is written.

In the latter case, as described above, since the low resistance state is maintained irrespective of the existence of the applied voltage once the resistance of the first state capacitor decreases, the bit data 0 stored in the capacitor C is not lost irrespective of the existence of the applied voltage.

The endurance of the to-be-tested capacitor was tested. The endurance test was repeatedly performed by making the to-be-tested capacitor become the first state capacitor, decreasing or increasing the resistance of the first state capacitor, and measuring the current of the first state capacitor.

FIG. 3 is a graph illustrating results of the endurance test. Symbol □ in FIG. 3 represents a current (referred to as a first current hereinafter) measured when the resistance of the first state capacitor is low, and symbol O in FIG. 3 represents a current (referred to as a second current hereinafter) measured when the resistance of the first state capacitor is high.

Referring to FIG. 3, the first current and the second current vary whenever they are measured in the endurance test, but the second current is more than 10 times greater than the first current.

These results indicate that the endurance of the capacitor according to the present invention is excellent. Since the second current is more than 10 times greater than the first current as seen from the endurance test results, whether the measured current of the to-be-tested capacitor is the first current or the second current is clearly distinguished. This means that data stored in the capacitor of the present invention can be read correctly even after a long time has passed.

A semiconductor memory device M comprising the capacitor C of FIG. 1 will now be explained with reference to FIG. 4.

Referring to FIG. 4, field oxide layers 52 are formed on predetermined areas of a substrate 50. A transistor is formed on the substrate 50 between the field oxide layers 52. That is, a gate 54 is formed on the substrate 50 between the field oxide layers 52. A source region S and a drain region D are respectively formed on the substrate 50 between the gate 54 and the field oxide layers 52 through implantation of conductive impurities. An interlayer insulating layer 56, e.g., a boron-phosphorous-silicate glass (BPSG) layer, is formed on the substrate 50 to cover the field oxide layers 52 and the transistor. A contact hole h is formed in the interlayer insulating layer 56. The drain region D is exposed by the contact hole h. The contact hole h is filled with a conductive plug 58. A diffusion barrier 60 is formed on the interlayer insulating layer 56 to cover the conductive plug 58. The capacitor C is formed on the diffusion barrier 60. The capacitor C preferably includes the lower electrode 40, the dielectric layer 42, and the upper electrode 44 as described with reference to FIG. 1.

In the meantime, when the lower electrode 40 and the dielectric layer 42 are properly selected or the lower electrode 40 itself can prevent carriers from being diffused to the conductive plug 58 from the capacitor C, the diffusion barrier 60 may not be required.

It is preferable that a surface area of the capacitor C is large. Accordingly, the capacitor may not be a simple stacked capacitor, but may be a more complex three-dimensional capacitor, such as a cylinder-type stacked capacitor.

A method of manufacturing the aforesaid semiconductor memory device M may include forming the transistor on the substrate 50 in a typical way, forming the interlayer insulating layer 56 on the substrate 50 to cover the transistor, forming the contact hole h in the interlayer insulating layer 56 to expose the drain region D of the transistor, filling the contact hole h with the conductive plug 58, and forming the capacitor C on the interlayer insulating layer 56 to contact the conductive plug 58. Here, the diffusion barrier 60 may be formed between the conductive plug 58 and the capacitor C. As shown in FIG. 1, the capacitor C may be formed by forming the lower electrode 40, stacking the dielectric layer 42, which includes the first insulating layer 42a, the phase-transition layer 42b, and the second insulating layer 42c, on the lower electrode 40, and stacking the upper electrode 44 on the dielectric layer 42. The first insulating layer 42a may be a dielectric layer having a first thickness, for example, a silicon oxide layer, a tantalum oxide layer, or an aluminium oxide layer. The second insulating layer 42c may be a dielectric layer having a second thickness, for example, a silicon oxide layer, a tantalum layer, or a aluminium layer. The phase-transition layer 42b may be a dielectric layer having a third thickness and display different resistance characteristics according to a range of an applied voltage after the insulation thereof is destroyed by electrons injected thereinto. For example, the phase-transition layer 42b may be an oxide layer of group-V atoms. A niobium layer is preferably used as the oxide layer of V-group atoms but other oxide layer can be used. The first, second, and third thicknesses can be the same, but it is preferable that a ratio of the first, second, and third thicknesses is 5:6:5. For example, when both the lower electrode 42 and the upper electrode 44 have a thickness of 40Å, the phase-transition layer 42 may have a thickness of 60Å. The electrons used to cause a phase transition of the phase-transition layer 42b, that is, used to cause the phase-transition layer 42b to display different resistance characteristics in different voltage ranges, may be injected to the phase-transition layer 42b by applying a predetermined voltage to the capacitor C. Here, the predetermined voltage applied to the capacitor C is a voltage at which the insulation of the phase-transition layer 42b is changed or destroyed. In this process, it is preferable that a voltage across the phase-transition layer 42b is equal to or greater than a voltage across the first and second insulating layers 42 and 44. Accordingly, it is preferable that the phase-transition layer 42b has a dielectric constant less than that of the dielectric layers used as the first and second insulating layers 42 and 44.

On the other side, the electrons used to destroy the insulation of the phase-transition layer 42b can be injected to the phase-transition layer 42b by externally applying electrons with energy, which is high enough to pass through the upper electrode 44 and reach the phase-transition layer 42b, to the capacitor C, instead of applying the predetermined voltage to the capacitor C. Or, if the phase-transition layer 42b is the niobium oxide layer, the insulation of the phase-transition layer 42b can also be destroyed by applying light beams, preferably, ultraviolet rays, with energy, which is high enough to separate some components, at least one oxygen, of the phase-transition layer, to the capacitor C. The first and second insulating layers 42a and 42c prevent the separated oxygen from being discharged out of the phase-transition layer 42b.

A method of operating the semiconductor memory device M shown in FIG. 4 will now be explained.

### Write Operation

First, a voltage capable of destroying the insulation of the dielectric layer of the capacitor C is applied to the capacitor C to destroy the insulation of the dielectric layer. As the insulation of the dielectric layer is destroyed, the capacitor C becomes the first state capacitor having the resistance characteristics as described with reference to FIG. 2.

If the first voltage is applied to the first state capacitor, the resistance of the first state capacitor is lowered, and if the second voltage is applied to the first state capacitor, the resistance of the first state capacitor is raised.

Hence, after the insulation of the dielectric layer is destroyed and the transistor is turned on, the bit data 1 can be written by applying the first voltage to the first state capacitor, or the bit data 0 can be written by applying the second voltage to the first state capacitor. Here, the written bit data values may be opposite.

### Read Operation

When an arbitrary bit data is written to the semiconductor memory device M of FIG. 4, the resistance of the phase-transition layer 42 varies according to the written bit data. Accordingly, the transistor is turned on, and the current of the capacitor is measured by applying a predetermined read voltage to the capacitor. Here, if the measured current value is greater than a reference value, it is determined that the bit data 1 is read from the semiconductor memory device M. If the measured current value is less than the reference value, it is determined that the bit data 0 is read from the semiconductor memory device M. The bit data according to the measured current values may be opposite. That is, the bit data 1 may be the bit data 0, and the bit data 0 may be the bit data 1.

As described above, the dielectric layer of the capacitor according to the present invention includes the phase-transition layer with two phases such that the phase-transition layer displays different resistance characteristics according to the range of the applied voltage and maintains the characteristics irrespective of the existence of the applied voltage after the insulation thereof is changed and destroyed by the injected electrons. The capacitor can be easily manufactured using the typical semiconductor manufacturing process, and an additional process is not needed. Consequently, when the capacitor of the present invention is applied to a general nonvolatile semiconductor memory device, such as a DRAM, the semiconductor memory device can maintain its original operation speed and have nonvolatile characteristics. That is, the semiconductor memory device comprising the capacitor according to the present invention can have advantages of both the DRAM and flash memory.

While the present invention has been particularly shown and described with reference to exemplary embodiments thereof, it will be understood by those of ordinary skill in the art that various changes in form and details may be made therein without departing from the scope of the present invention as defined by the following claims. For example, the transistor may be a thin film transistor, and some of the layers constituting the dielectric layer 42 may be ferroelectric layers. Moreover, a semiconductor memory device other than the semiconductor memory device shown in FIG. 4 may include the capacitor shown in FIG. 1. Accordingly, the present invention is defined by the following claims, not by the previously mentioned embodiments.

## Claims

1. A capacitor of a semiconductor device, the capacitor comprising:
a lower electrode;
a dielectric layer stacked on the lower electrode and including a phase-transition layer, which displays two remarkably different, resistance characteristics after insulating property thereof is changed; and
an upper electrode stacked on the dielectric layer.

2. The capacitor of claim 1, wherein the dielectric layer comprises:
a first insulating layer stacked on the lower electrode;
the phase-transition layer stacked on the first insulating layer; and
a second insulating layer stacked on the phase-transition layer.

3. The capacitor of claim 2, wherein the first insulating layer is a dielectric layer with a dielectric constant greater than that of the phase-transition layer.

4. The capacitor of claim 3, wherein the dielectric layer is one of a silicon oxide layer, a tantalum oxide layer and an aluminum oxide layer.

5. The capacitor of claim 2, 3 or 4, wherein the second insulating layer is a dielectric layer with a dielectric constant greater than that of the phase-transition layer.

6. The capacitor of claim 5, wherein the dielectric layer is one of a silicon oxide layer, a tantalum oxide layer, and an aluminum oxide layer.

7. The capacitor of any preceding claim, wherein the phase-transition layer is a dielectric layer, which displays two remarkably different resistance characteristics according to an applied voltage after at least one component of the phase-transition layer is separated by electrons injected into the phase-transition layer.

8. The capacitor of claim 7, wherein the phase-transition dielectric layer is a niobium oxide layer.

9. The capacitor of any one of claims 2 to 6, wherein a thickness ratio of the first insulating layer, the phase-transition layer, and the second insulating layer is 5:6:5.

10. A semiconductor memory device including a transistor and a capacitor, the capacitor comprising:
a lower electrode;
a dielectric layer stacked on the lower electrode and including a phase-transition layer, which displays two remarkably different resistance characteristics after insulating property thereof is changed; and
an upper electrode stacked on the dielectric layer.

11. The semiconductor memory device of claim 10, wherein the dielectric layer comprises:
a first insulating layer stacked on the lower electrode;
the phase-transition layer stacked on the first insulating layer; and
a second insulating layer stacked on the phase-transition layer.

12. The semiconductor memory device of claim 11, wherein the first insulating layer is a dielectric layer with a dielectric constant greater than that of the phase-transition layer.

13. The semiconductor memory device of claim 12, wherein the dielectric layer is one of a silicon oxide layer, a tantalum oxide layer, and an aluminum oxide layer.

14. The semiconductor memory device of claim 11, 12 or 13, wherein the second insulating layer is a dielectric layer with a dielectric constant greater than that of the phase-transition layer.

15. The semiconductor memory device of claim 14, wherein the dielectric layer is a silicon oxide layer, a tantalum oxide layer, or an aluminum oxide layer.

16. The semiconductor memory device of any one of claims 10 to 15, wherein the phase-transition layer is a dielectric layer, which displays two remarkably different resistance characteristics according to a range of an applied voltage after at least one component of the phase-transition layer is separated by electrons injected into the phase-transition layer.

17. The semiconductor memory device of claim 16, wherein the phase-transition dielectric layer is a niobium oxide layer.

18. The semiconductor memory device of any one of claims 11 to 15, wherein a thickness ratio of the first insulating layer, the phase-transition layer, and the second insulating layer is 5:6:5.

19. A method of operating a semiconductor memory device including a transistor and a capacitor, wherein the capacitor comprises a lower electrode, a dielectric layer including a phase-transition layer, which displays two remarkably different resistance characteristics after insulating property thereof is changed, and an upper electrode, the method comprising:
changing insulating property of the phase-transition layer; and
applying a write voltage to the capacitor while leaving the transistor turned on.

20. The method of claim 19, wherein the insulating property of the phase-transition layer is changed by injecting electrons to the phase-transition layer.

21. The method of claim 20, wherein the electrons are injected to the phase-transition layer by applying a voltage to the capacitor.

22. A method of operating a semiconductor memory device including a transistor and a capacitor, wherein the capacitor comprises a lower electrode, a dielectric layer including a phase-transition layer, which displays two remarkably different resistance characteristics after insulating property thereof is changed, and an upper electrode, the method comprising:
measuring a current by applying a read voltage to the capacitor while leaving the transistor turned on; and
comparing the measured current value with a reference value.
